# FASCICULE DE BREVET EUROPEEN

(11) **EP 4 593 553 B1**
(45) Date de publication et mention de la délivrance du brevet: **09.09.2026**
(21) Numéro de dépôt: 25151585.4
(22) Date de dépôt: 13.01.2025
(51) Int. Cl.: H10D 89/60

(54) **DISPOSITIF ELECTRONIQUE**
ELEKTRONISCHE VORRICHTUNG
ELECTRONIC DEVICE

(30) Priorité: 23.01.2024 FR 2400632
(43) Date de publication de la demande: 30.07.2025
(73) Titulaire: STMicroelectronics International N.V., 1228 Plan-les-Ouates, Genève (CH)
(72) Inventeur: GRANGE, Karl, 37100 Tours (FR)
(74) Mandataire: Cabinet Beaumont

(56) Documents cités:
- US-A- 5 138 413
- US-A1- 2011 199 346

## Description

### Domaine technique

La présente description concerne de façon générale les dispositifs électroniques et plus précisément les connexions d'entrée et de sortie de dispositifs électroniques.

### Technique antérieure

Dans les dispositifs électroniques semiconducteurs recevant des tensions extérieures, la tension de référence est par exemple la tension à laquelle est polarisée le substrat.

Dans certains dispositifs électroniques, l'application de tensions inférieures à la tension de référence peuvent entrainer des fuites n'étant pas présentes lors de l'application de tensions supérieures à la tension de référence. Dans d'autres dispositifs électroniques, l'application de tensions supérieures à la tension de référence peuvent entrainer des fuites n'étant pas présentes lors de l'application de tensions inférieures à la tension de référence.

US 5,138,413 A et US 2011/0199346 A1 décrivent des dispositifs électroniques selon le préamble de la revendication 1.

### Résumé de l'invention

Un mode de réalisation pallie tout ou partie des inconvénients des dispositifs électroniques connus.
la revendication prévoit un dispositif électronique comprenant un substrat et au moins un premier plot d'entrée/sortie, chaque premier plot étant relié au substrat par un ensemble, chaque ensemble comprenant des premier et deuxième caissons, le premier caisson étant situé dans le deuxième caisson, le deuxième caisson étant situé dans le substrat, le substrat et le premier caisson de chaque ensemble étant dopé d'un premier type de conductivité, le deuxième caisson de chaque ensemble étant dopé d'un deuxième type de conductivité opposé au premier type de conductivité, chaque ensemble étant configuré pour que la tension de seuil de la diode formée par les premier et deuxième caissons de l'ensemble soit :
- inférieure à la tension de seuil de la diode formée par le deuxième caisson et le substrat, lorsque le premier type de conductivité est le type P ; ou
- supérieure à la tension de seuil de la diode formée par le deuxième caisson et le substrat, lorsque le premier type de conductivité est le type N.

Selon un mode de réalisation, le premier caisson de chaque ensemble est relié au substrat par un élément externe au substrat.

Selon un mode de réalisation, le premier caisson de chaque ensemble est relié au substrat par un élément filaire.

Selon un mode de réalisation, le dispositif comprend au moins deux premiers plots.

Selon un mode de réalisation, le premier caisson de chaque ensemble est séparé du substrat par le deuxième caisson du même ensemble.

Selon un mode de réalisation, le dispositif comprend un deuxième plot d'entrée/sortie relié au substrat par un ensemble, le deuxième plot étant configuré pour recevoir une tension de référence.

Selon un mode de réalisation, la tension de référence est un potentiel nul.

Selon un mode de réalisation, les premiers plots sont reliés à un circuit électronique.

Selon un mode de réalisation, le circuit électronique comprend des transistors bipolaires.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un dispositif électronique selon un mode de réalisation ; et
la figure 2 représente schématiquement le dispositif de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

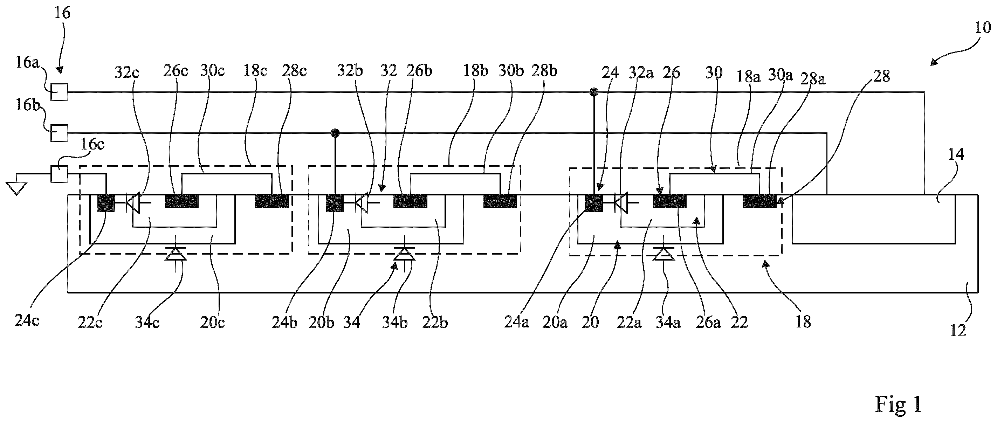

La figure 1 représente un dispositif électronique 10 selon un mode de réalisation.

Le dispositif 10 correspond par exemple à une puce électronique. Le dispositif 10 comprend un substrat semiconducteur 12. Le substrat 12 est par exemple en silicium. Le substrat 12 est dopé en un premier type de conductivité, par exemple de type P.

Le dispositif 10 comprend au moins un circuit électronique 14. Le circuit 14 est par exemple configuré pour effectuer au moins une fonction. Le circuit 14 est par exemple un circuit de gestion de puissance. Plus précisément, le dispositif 10 comprend des composants électroniques formant le circuit 14. Les composants électroniques du circuit 14 sont par exemple formés dans et sur le substrat 12. Le dispositif 10 est par exemple un dispositif électronique de contrôle destinés à être intégré dans des équipements électriques, électromécaniques ou optoélectroniques. Le dispositif 10 est par exemple destiné à être intégré dans des équipements industriels, des équipements électroménagers, ou des équipements automobiles, pour le contrôle de ces équipements. Le dispositif 10 est par exemple adapté à contrôler des équipements via des bus filaires de type LIN ou CAN. Le dispositif 10 est par exemple adapté à contrôler des équipements selon la norme IEC 61131-2.

Le circuit 14 est relié à au moins un plot 16 d'entrée/sortie, de préférence un plot d'entrée. Dans l'exemple de la figure 1, le circuit 14 est relié à deux plots d'entrée/sortie 16a et 16b. Chacun des deux plots d'entrée/sortie 16 est par exemple configuré pour recevoir une tension d'entrée. De même, le circuit 14 est configuré pour recevoir lesdites tensions d'entrée. Par exemple, au moins un plot 16 est relié, de préférence connecté, à une borne d'un transistor du circuit 14, par exemple un transistor bipolaire, un transistor MOSFET, ou autre.

Le dispositif 10 comprend en outre un plot d'entrée/sortie 16c. Le plot 16c est configuré pour recevoir une tension de référence, par exemple la masse. Le plot 16c est par exemple configuré pour recevoir un potentiel nul.

Chaque plot d'entrée 16 est en outre relié au substrat 12 par l'intermédiaire d'un ensemble 18. Plus précisément, le plot 16a est relié au substrat 12 par un ensemble 18a. Le plot 16b est relié au substrat 12 par un ensemble 18b. Le plot 16c est relié au substrat 12 par un ensemble 18c. De préférence, le dispositif 10 ne comprend pas de plot d'entrée/sortie directement connecté au substrat 12.

Chaque ensemble 18 comprend un premier caisson 20. Le caisson est situé dans le substrat 12. Le caisson 20 affleure de préférence une face supérieure du substrat 12. Le caisson 20 est en un matériau semiconducteur, par exemple le même matériau que le substrat 12. Le caisson 20 est dopé du type de conductivité opposé au type de conductivité du substrat 12. Le caisson 20 est par exemple dopé de type N.

Chaque ensemble 18 comprend en outre un caisson 22 situé dans le caisson 20. Le caisson 20 affleure de préférence une face supérieure du caisson 20. Les faces supérieures du substrat 12 et des caissons 20 et 22 sont par exemple coplanaires. Le caisson 22 est par exemple entièrement entouré par le caisson 20, à l'exception de sa face supérieure. Le caisson 22 est entièrement séparé du substrat 12 par le caisson 20. Le caisson 22 est en un matériau semiconducteur, par exemple le même matériau que le substrat 12 et que le caisson 20. Le caisson 22 est dopé du type de conductivité opposé au type de conductivité du caisson 20, c'est-à-dire le même type de conductivité que le substrat 12. Le caisson 22 est par exemple dopé de type P.

Ainsi, l'ensemble 18a comprend des caissons 20 et 22, référencés 20a et 22a, tels que décrits précédemment. L'ensemble 18b comprend des caissons 20 et 22, référencés 20b et 22b, tels que décrits précédemment. L'ensemble 18c comprend des caissons 20 et 22, référencés 20c et 22c, tels que décrits précédemment.

Chaque ensemble 18 comprend en outre un contact 24. Le contact 24 est situé dans le caisson 20 du même ensemble 18. Le contact 24 correspond par exemple à une région du caisson 20 du même ensemble, plus fortement dopée que le reste du caisson 20. Le contact 24 est relié, de préférence connecté, au plot 16 associé à l'ensemble 18 du contact 24. Le contact 24 d'au moins certains des ensembles 18, par exemple de tous les ensembles autres que l'ensemble 18c, est par exemple relié, de préférence connecté, au circuit 14. Ainsi, le caisson 20 de chaque ensemble 18 est polarisé à la tension fournie sur le plot 16 associé à l'ensemble 18.

Chaque ensemble 18 comprend en outre un contact 26. Le contact 26 est situé dans le caisson 22 du même ensemble 18. Le contact 26 correspond par exemple à une région du caisson 22 du même ensemble, plus fortement dopée que le reste du caisson 22.

Chaque ensemble 18 comprend en outre un contact 28. Le contact 28 est situé dans le substrat 12, par exemple autour du caisson 20. Le contact 28 correspond par exemple à une région du substrat 12, par exemple une région du substrat située autour du caisson 20, plus fortement dopée que le reste du substrat 12.

Les régions 26 et 28 d'un même ensemble 18 sont reliés, de préférence connectés, de préférence par un élément de connexion externe au substrat 12. Par exemple, les régions 26 et 28 d'un même ensemble 18 sont reliés, de préférence connectés, par un élément filaire, par exemple un fil métallique 30.

Dans le cas du dispositif 10 de la figure 1, l'ensemble 18a comprend des contacts 24, 26, 28, référencés 24a, 26a et 28a, et un élément de connexion 30, référencé 30a, tels que décrits précédemment. L'ensemble 18b comprend des contacts 24, 26, 28, référencés 24b, 26b et 28b, et un élément de connexion 30, référencé 30b, tels que décrits précédemment. L'ensemble 18c comprend des contacts 24, 26, 28, référencés 24c, 26c et 28c, et un élément de connexion 30, référencé 30c, tels que décrits précédemment.

La jonction PN située entre les caissons 20 et 22 d'un même ensemble 18, c'est-à-dire la jonction PN formée à l'interface entre les caissons 20 et 22 d'un même ensemble 18, constitue une diode 32. Similairement, la jonction PN située entre le caisson 20 d'un ensemble et le substrat 12 entourant ledit ensemble 18, c'est-à-dire la jonction PN formée à l'interface entre le caisson 20 d'un ensemble et le substrat 12 entourant ledit ensemble 18, constitue une diode 34, dite parasite. De manière illustrative, les diodes 32 et 34 sont représentées schématiquement par leur symbole en figure 1.

Dans l'exemple de la figure 1, les niveaux de dopage du substrat 12 et des caissons 20 et 22 sont choisis de telle manière que le courant de saturation de la diode 32 d'un ensemble 18 soit plus fort d'au moins une décade par rapport au courant de saturation du transistor 34 du même ensemble. Par exemple, la jonction PN entre les caissons 20 et 22 d'un même ensemble 18 est configurée pour être abrupte, alors que la jonction entre le caisson 20 de cet ensemble et le substrat 12 est configuré pour être plus graduelle.

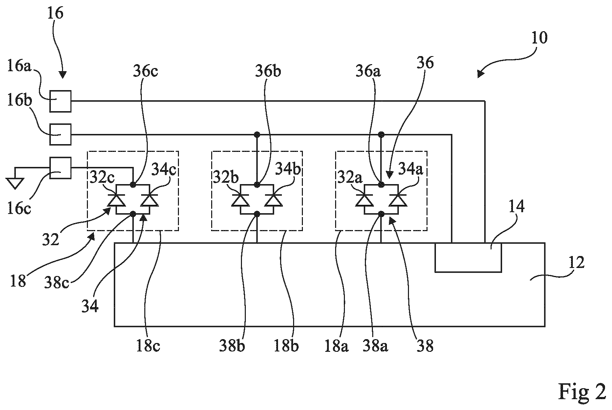

La figure 2 représente schématiquement le dispositif 10 de la figure 1.

La figure 2 représente, comme la figure 1, le substrat 12 et le circuit 14 situé dans le substrat 12. La figure 2 représente en outre les plots 16 d'entrée sortie, plus précisément les plots 16a, 16b et 16c de la figure 1. Comme en figure 1, le plot 16c est relié à une source, par exemple externe au substrat 12, d'une tension de référence.

Comme en figure 1, au moins certains plots 16, par exemple les plots 16 autres que le plot 16 recevant la tension de référence, sont relié, de préférence connecté, au circuit 14. Chaque plot 16 est en outre relié au substrat 12 par un ensemble 18. Chaque ensemble 18 comprend, en figure 2, une diode 32 et une diode 34.

Les diodes 32 et 34 d'un ensemble 18 sont reliées en parallèle entre un noeud 36 et un noeud 38. Ainsi, les diodes 32a et 34a sont reliées en parallèle entre le noeud 36a et le noeud 38a. Les diodes 32b et 34b sont reliées en parallèle entre le noeud 36b et le noeud 38b. Les diodes 32c et 34c sont reliées en parallèle entre le noeud 36c et le noeud 38c. Chaque noeud 36 est relié, de préférence connecté, au plot 16 associé à l'ensemble 18. Chaque noeud 38 est relié, de préférence connecté, au substrat 12. Ainsi, les cathodes des diodes 32 et 34 d'un ensemble sont reliées, de préférence connectées, ensembles et reliées, de préférence connectées, au plot 16 associé à l'ensemble. Les anodes des diodes 32 et 34 d'un ensemble sont reliées, de préférence connectées, ensembles et reliées, de préférence connectées, au substrat 13.

Les cathodes des diodes 32 et 34 d'un ensemble 18 sont constituées par le caisson 20 dudit ensemble 18. L'anode de la diode 34 de l'ensemble est constituée par le substrat 12. L'anode de la diode 32 est constituée par le caisson 22. La liaison entre l'anode de la diode 32 et le substrat 12 est effectuée par l'élément de connexion 30 de l'ensemble.

Comme décrit en relation avec figure 1, la tension de seuil de la diode 32 est inférieure à la tension de seuil de la diode 34. Ainsi, lors du fonctionnement du dispositif 10, le substrat 12 est polarisé à la tension la plus faible parmi les tensions reçues sur les plots 16. La masse du circuit 14 est ainsi la tension la plus faible parmi les tensions fournies sur les plots 16. Les différences de potentiel entre les plots 16, par exemple entre le plot 16a ou 16b et le plot 16c, restent identiques. Cependant, les tensions sont toutes des tensions positives.

On aurait pu choisir de ne pas prévoir les éléments 18 dans le dispositif 10, et ainsi de relier directement le plot 16c au substrat et les autres plots directement au circuit 14. Cependant, dans ce cas, lors de l'application de tensions négatives au circuit 14 et en particulier aux transistors bipolaires, un fort courant de fuite serait formé entre le transistor bipolaire et le substrat.

Selon un autre mode de réalisation non représenté, les types de conductivité peuvent être inversés. Ainsi, dans cet autre mode de réalisation, le substrat 12 est dopé de type N, les caissons 20 sont dopés de type P et les caissons 22 sont dopés de type N. Les diodes 32, et les niveaux de dopages des caissons 20, 22 et du substrat 12, sont alors configurés pour que le courant de saturation de la diode 32 soit supérieur d'au moins une décade au courant de saturation de la diode 34. Ce mode de réalisation est par exemple adapté à des dispositifs dans lesquels l'application d'une tension positive risquerait de générer des courants de fuite plus importants que l'application d'une tension négative. Le dispositif comprend par exemple des transistors bipolaires de type NPN dans le circuit 14.

Un avantage des modes de réalisation décrits est que le dispositif génère moins de courants de fuite.

L'invention est définie par les revendications.

## Revendications

1. Dispositif électronique (10) comprenant un substrat (12) et au moins un premier plot d'entrée/sortie (16a, 16b), chaque premier plot (16a, 16b) étant relié au substrat (12) par un ensemble (18), chaque ensemble (18) comprenant des premier (22) et deuxième (20) caissons, le premier caisson (22) étant situé dans le deuxième caisson (20), le deuxième caisson (20) étant situé dans le substrat (12), le substrat (12) et le premier caisson (22) de chaque ensemble (18) étant dopé d'un premier type de conductivité, le deuxième caisson (20) de chaque ensemble étant dopé d'un deuxième type de conductivité opposé au premier type de conductivité, **caractérisé en ce que** chaque ensemble (18) est configuré pour que la tension de seuil de la diode (32) formée par les premier et deuxième caissons de l'ensemble (18) soit :
- inférieure à la tension de seuil de la diode (34) formée par le deuxième caisson (20) et le substrat (12), lorsque le premier type de conductivité est le type P ; ou
- supérieure à la tension de seuil de la diode (34) formée par le deuxième caisson (20) et le substrat (12), lorsque le premier type de conductivité est le type N.

2. Dispositif selon la revendication 1, dans lequel le premier caisson (22) de chaque ensemble (18) est relié au substrat (12) par un élément externe au substrat (12).

3. Dispositif selon la revendication 2, dans lequel le premier caisson (22) de chaque ensemble (18) est relié au substrat (12) par un élément filaire (30).

4. Dispositif selon l'une quelconque des revendications 1 à 3, dans lequel le dispositif comprend au moins deux premiers plots (16a, 16b).

5. Dispositif selon l'une quelconque des revendications 1 à 4, dans lequel le premier caisson (22) de chaque ensemble (18) est séparé du substrat (12) par le deuxième caisson (20) du même ensemble (18).

6. Dispositif selon l'une quelconque des revendications 1 à 5, dans lequel le dispositif comprend un deuxième plot (16c) d'entrée/sortie relié au substrat (12) par un ensemble (18), le deuxième plot (16c) étant configuré pour recevoir une tension de référence.

7. Dispositif selon la revendication 6, dans lequel la tension de référence est un potentiel nul.

8. Dispositif selon l'une quelconque des revendications 1 à 7, dans lequel les premiers plots (16a, 16b) sont reliés à un circuit électronique (14).

9. Dispositif selon la revendication 8, dans lequel le circuit électronique (14) comprend des transistors bipolaires.

## Patentansprüche

1. Elektronische Einrichtung (10), die ein Substrat (12) und wenigstens einen ersten Eingangs-/Ausgangskontakt (16a, 16b) aufweist, wobei jeder erste Kontakt (16a, 16b) mit dem Substrat (12) durch eine Anordnung (18) verbunden ist, wobei jede Anordnung (18) erste (22) und zweite (20) Wannen aufweist, wobei die erste Wanne (22) in der zweiten Wanne (20) angeordnet ist, wobei die zweite Wanne (20) in dem Substrat (12) angeordnet ist, wobei das Substrat (12) und die erste Wanne (22) jeder Anordnung (18) mit einem ersten Leitfähigkeitstyp dotiert sind, wobei die zweite Wanne (20) jeder Anordnung mit einem zweiten Leitfähigkeitstyp, der dem ersten Leitfähigkeitstyp entgegengesetzt ist, dotiert ist,
**dadurch gekennzeichnet, dass** jede Anordnung (18) derart eingerichtet ist, dass die Schwellenspannung der durch die erste und zweite Wanne der Anordnung (18) gebildeten Diode (32):
- niedriger ist als die Schwellenspannung der Diode (34), die durch die zweite Wanne (20) und das Substrat (12) gebildet wird, wenn der erste Leitfähigkeitstyp Typ P ist; oder
- höher ist als die Schwellenspannung der Diode (34), die durch die zweite Wanne (20) und das Substrat (12) gebildet wird, wenn der erste Leitfähigkeitstyp Typ N ist.

2. Einrichtung nach Anspruch 1, wobei die erste Wanne (22) jeder Anordnung (18) mit dem Substrat (12) durch ein Element, das außerhalb des Substrats (12) liegt, verbunden ist.

3. Einrichtung nach Anspruch 2, wobei die erste Wanne (22) jeder Anordnung (18) mit dem Substrat (12) durch ein Drahtelement (30) verbunden ist.

4. Einrichtung nach einem der Ansprüche 1 bis 3, wobei die Einrichtung wenigstens zwei erste Kontakte (16a, 16b) aufweist.

5. Einrichtung nach einem der Ansprüche 1 bis 4, wobei die erste Wanne (22) jeder Anordnung (18) von dem Substrat (12) durch die zweite Wanne (20) derselben Anordnung (18) getrennt ist.

6. Einrichtung nach einem der Ansprüche 1 bis 5, wobei die Einrichtung einen zweiten Eingangs-/Ausgangskontakt (16c) aufweist, der mit dem Substrat (12) durch eine Anordnung (18) verbunden ist, wobei der zweite Kontakt (16c) eingerichtet ist zum Empfangen einer Referenzspannung.

7. Einrichtung nach Anspruch 6, wobei die Referenzspannung ein Nullpotential ist.

8. Einrichtung nach einem der Ansprüche 1 bis 7, wobei die ersten Kontakte (16a, 16b) mit einer elektronischen Schaltung (14) verbunden sind.

9. Einrichtung nach Anspruch 8, wobei die elektronische Schaltung (14) Bipolartransistoren aufweist.

## Claims

1. Electronic device (10) comprising a substrate (12) and at least one first input/output pad (16a, 16b), each first pad (16a, 16b) being coupled to the substrate (12) by an assembly (18), each assembly (18) comprising first (22) and second (20) wells, the first well (22) being located in the second well (20), the second well (20) being located in the substrate (12), the substrate (12) and the first well (22) of each assembly (18) being doped with a first conductivity type, the second well (20) of each assembly being doped with a second conductivity type opposite to the first conductivity type, **characterized in that** each assembly (18) is configured so that the threshold voltage of the diode (32) formed by the first and second wells of the assembly (18) is:
- lower than the threshold voltage of the diode (34) formed by the second well (20) and the substrate (12), when the first conductivity type is type P; or
- higher than the threshold voltage of the diode (34) formed by the second well (20) and the substrate (12), when the first conductivity type is type N.

2. Device according to claim 1, wherein the first well (22) of each assembly (18) is coupled to the substrate (12) by an element external to the substrate (12).

3. Device according to claim 2, wherein the first well (22) of each assembly (18) is coupled to the substrate (12) by a wire element (30).

4. Device according to any of claims 1 to 3, wherein the device comprises at least two first pads (16a, 16b).

5. Device according to any of claims 1 to 4, wherein the first well (22) of each assembly (18) is separated from the substrate (12) by the second well (20) of the same assembly (18).

6. Device according to any of claims 1 to 5, wherein the device comprises a second input/output pad (16c) coupled to the substrate (12) by an assembly (18), the second pad (16c) being configured to receive a reference voltage.

7. Device according to claim 6, wherein the reference voltage is a zero potential.

8. Device according to any of claims 1 to 7, wherein the first pads (16a, 16b) are coupled to an electronic circuit (14).

9. Device according to claim 8, wherein the electronic circuit (14) comprises bipolar transistors.
